Europäisches Patentamt

European Patent Office

Office européen des brevets

(19)

(11) **EP 0 436 397 B1**

(12) EUROPEAN PATENT SPECIFICATION

(45) Date of publication and mention
of the grant of the patent:
**30.10.1996 Bulletin 1996/44**

(51) Int Cl.6: **G10K 15/02**

(21) Application number: **90314403.8**

(22) Date of filing: **28.12.1990**

(54) **Sound synthesizer**

Schallsynthesizer

Synthétiseur de son

(84) Designated Contracting States:
**DE FR GB IT**

(30) Priority: **02.01.1990 US 459420**

(43) Date of publication of application:
**10.07.1991 Bulletin 1991/28**

(73) Proprietor: **RAYTHEON COMPANY**
**Lexington Massachusetts 02173 (US)**

(72) Inventors:
- **Rosenstrach, Paul A.**
**Newport, Rhode Island (US)**
- **Deaett, Michael A.**
**N. Kingstown, Rhode Island (US)**

(74) Representative: **Jackson, David Spence et al**
**REDDIE & GROSE**
**16, Theobalds Road**
**London, WC1X 8PL (GB)**

(56) References cited:
**EP-A- 0 209 336**          **FR-A- 2 510 288**

- **EUROSPEECH 89 vol. 2, September 1989, Paris,
pp. 187-190; A. FALASCHI et al.: 'A Hidden
Markov Model approach to speech synthesis'**
- **IEEE TRANSACTIONS ON INFORMATION
THEORY, vol. 31, no. 3, May 1985, New York, US,
pp. 348-359; J. FOSTER et al.: 'Finite-state vector
quantization for waveform coding'**
- **IEEE GLOBAL TELECOMMUNICATIONS
CONFERENCE & EXHIBITION, vol. 2/3, 28
November 1988, Hollywood, Florida, pp.
1068-1072; T. MURAKAMI et al.: 'Scene adaptive
vector quantization for image coding'**
- **EUROSPEECH 89 vol. 2, September 1989, Paris,
pp. 356-359; T.M. LIU et al.: 'Phonetically-based
LPC vector quantization of high quality speech'**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

EP 0 436 397 B1

## Description

This invention relates to a method of synthesizing a desired signal, comprising supplying a random noise signal as input to a recursive filter having a set of coefficient values which determine the output from the filter, while using as the set of coefficient values of the filter during each one of a sequence of block times (T) that corresponds to the duration of the desired signal a selected set of linear predictive coding (LPC) coefficients ($a_o$, ....., $a_n$), each such set of LPC coefficients ($a_o$, ....., $a_n$) being selected from a plurality of stored sets and supplied to the filter.

The invention also relates to apparatus for synthesizing a desired signal.

European patent no. 0 209 336 describes a method of the kind defined hereinbefore at the beginning. A desired signal for producing a sound is synthesized from stored data which are sets of the coefficients of a recursive filter where each set is applied to the filter for a fixed time period, the periods totalling the duration of the synthesized signal. To produce the stored data, a single analog sound transient was divided into time-blocks of equal length and for each block a set of coefficients for a linear predictive coding (LPC) circuit was obtained. The circuit provided a satisfactory replica of the signal from which the LPC modelling coefficients were obtained with a small variation in the sound of successive synthesized signals because of the randomness produced by the random noise source applied to the input of the linear predictive filter.

The modelling of non-stationary acoustic signatures, termed transients, is of critical importance in the design of detection processors and in the accurate production of synthetic signatures for sonar trainers, and test target generators. Sonar training, which involves the recognition of a contact's existence and maneuvering condition, requires an accurate interpretation of transient contact emissions which in turn must be faithfully generated by a contact synthesizer. Currently such sounds are provided by magnetic tape players which are cumbersome to use, are not synchronized with the evolving scenario, and produce distorted results due to recorded background noise. Transient detection processing which provides the means for identifying the otherwise quiet contacts, requires a transient signature model which not only is of high-fidelity, but, in addition, provides the basis for detection methods which are processing efficient.

Classified as transients are those signatures of possibly several hours duration which exhibit a rapid, yet statistically regular, pattern of spectral energy fluctuation. Examples of the sounds to be modeled include hatch closings, shrimp snaps, ice crackling, hull groans, shifting cargo, and steering actuator emissions.

As a result of LPC analysis/synthesis, a reasonable replication of the original sound is attained. The required synthesis is accomplished by a recursive filter as shown in Fig. 2 of European patent no. 0 209 336. The arithmetic burden required for the implementation of the synthesis is significant. Each output sample requires (N+1) multiply-accumulations where N is the number of filter coefficients. If the output data rate is $F_S$ samples per second, then (N+1) $F_S$ multiply-accumulations per second are required. An even more significant factor from an implementation viewpoint is the total number of modeling filter coefficients required for synthesizing a signature. These coefficients must be stored in a limited size synthesizer memory and therefore constitute a significant implementation burden. Every block of 8 millisecond duration, for instance, requires approximately ten coefficients and one gain value. The resulting number of bits of coefficient memory for LPC synthesis is thus, $N_c = (16)(125)(11)T_s = 22000 \, T_s$ bits of memory, where 16-bit words are used, 125 blocks per second are processed, 11 words per block are required, and $T_s$ is the total duration of signature synthesis in seconds. For direct synthesis from stored sample at an assumed 16 kHz sample rate, the required number of bits is $N_d = (16)(1.6 \times 10^4)T_s = 256,000 \, T_s$ bits so that a 10:1 data compression is accomplished. However, it can be seen that one megabit of PAM memory will support only 45 seconds of LPC synthesized sound. The synthesis requirement exists for non-stationary sounds which last for several hours, so, clearly, additional data compression is desirable.

According to one aspect of the present invention, a method of the kind defined hereinbefore at the beginning is characterised in that the selecting of and the supplying to the filter of each set of LPC coefficients ($a_o$, ....., $a_n$) comprises the steps of:

generating a probability value;
comparing the generated probability value with a selected set of cumulative probability values ($P_{ij}$) derived from the transition probabilities between the stored sets, for the desired signal, and determining the cumulative probability value ($P_{ij}$) indicated by the comparison in accordance with a predetermined criterion;
selecting a respective one of the stored sets corresponding to the indicated cumulative probability value ($P_{ij}$), each of the cumulative probability values ($P_{ij}$) being associated with a respective one of the stored sets;
applying the selected stored set ($a_o$, ....., $a_n$) to the recursive filter for the duration of a block time (T) ; and
selecting, in dependence upon the said indicated cumulative probability value ($P_{ij}$), a next set of cumulative probability values ($P_{ij}$) for comparison with a next generated probability value.

According to another aspect of the present invention there is provided apparatus for synthesizing a desired signal, comprising:

2

a recursive filter;

means for supplying a random noise signal as input to the recursive filter;

means for supplying to the filter for each one of a sequence of block times (T) a selected set of linear predictive coding (LPC) coefficients ($a_o$, ....., $a_n$), the sequence of block times (T) corresponding to the duration of the desired signal, and the filter being such as to provide an output determined by the set of LPC coefficients supplied thereto, whereby the filter produces during the sequence of block times (T) the desired signal in dependence upon the supplied sequence of sets of LPC coefficients; and

means for storing the sets;

characterised in that the means for supplying the selected sets of LPC coefficients comprises:

means for generating a probability value;

means for supplying a selected set of cumulative probability values ($P_{ij}$) derived from the transition probabilities between the stored sets, for the desired signal, to the comparing means; and

means for comparing a generated probability value with a selected set of cumulative probability values ($P_{ij}$), determining the cumulative probability value ($P_{ij}$) indicated by the comparison in accordance with a predetermined criterion, and selecting a respective one of the stored sets of LPC coefficients corresponding to the indicated cumulative probability value ($P_{ij}$) to be supplied to the filter, the means for supplying a selected set of cumulative probability values ($P_{ij}$) including means for associating each of the cumulative probability values ($P_{ij}$) with a respective one of the stored sets of LPC coefficients ($a_o$, ....., $a_n$), and for selecting, in dependence upon the said indicated cumulative probability value ($P_{ij}$), a next set of cumulative probability values ($P_{ij}$) for comparison with a next generated probability value.

It is an objective of the preferred modelling procedure of this invention to abstract the distinguishing sound characteristics and to parameterize them via a probabilistic model. In a preferred embodiment, the sets of coefficients include the probabilistic modelling of non-repetitive ensembles of transient sounds by means of Markov transitions over sets of vector quantized linear predictive coding (LPC) modelling coefficients.

A preferred embodiment of this invention provides a method of synthesizing pseudo random signatures which are non-repetitive in nature. Prior art synthesizers produce generated signatures which are virtually identical upon each generation instance. This repetition is not realistic. Therefore, capturing the essential patterns of variations which exist within a class of sounds is important and is provided by the preferred embodiment.

While direct LPC techniques lead to acceptable signatures, the coefficient sets utilized result in a large data base which is not easily amenable to further modelling abstraction. Therefore, a further step in data reduction is required in order to reduce this data base to a small set of modelling coefficients into which all of the modelling coefficients sets can be mapped. The mapping introduces a further, although insignificant, distortion in the synthesized signal which is evaluated by means of the likelihood ratio distortion measure. The mapping process employed is single-pass vector quantization by which acceptable synthesized signatures can be produced by using a limited number of representative coefficient sets called "clusters". A time series of clusters, which is termed "a cluster observation sequence", results from the mapping of each block's set of LPC coefficients into a cluster.

The method of synthesis of European patent no. 0 209 336 has been extended in a preferred embodiment of this invention to include probabilistic models by means of Markov transitions derived from the non-repetitive ensemble of cluster observation sequences produced by a transient sound. The sound which is so characterized is considered to exhibit the two characteristic excitation states, background generation and transient generation. In each characteristic state, the sequential evolution of the cluster observation sequence is viewed as a Markov chain which is governed bv a time varying Markov transition matrix. Two different classes of sound signatures, periodic and Poisson-excited, are modeled. In the case of periodic processes, such as cavitation, the transient state is continually exhibited and a periodic sequence of transition matricies repetitively characterizes the sound. In the case of long term transients, the transient generation state is entered according to a Poisson event process. Between transient states, the background state which is characterized by a distinct transition matrix is entered. The resulting clusters together with the Markov transition matrices are employed to provide an efficient method of long term transient signature synthesis.

Brief Description of the Drawings

The foregoing features of this invention, as well as the invention itself, may be more fully understood from the following detailed description of the drawings, in which:

FIG. 1 is a graphical representation of transient signals used before analysis in obtaining the probability-weighted vector quantised sets of linear prediction coefficients of a recursive filter.

FIG. 2 shows graphically the distribution of clusters for four of the waveforms of FIG. 1.

FIG. 3 shows the probability of a transition from one cluster in one block to one of the possible clusters of the next successive block.

FIG. 4 shows the cumulative probability of a transition from one cluster of one block to one of the possible clusters in the next successive block.

FIGs. 5A and 5B show a cluster transition probabilities and cumulative transition probabilities, respectively, for a different probability distribution than assumed for FIGs. 3A - 3D and 4A - 4D, respectively.

FIG. 6 shows in block diagram form apparatus for selecting clusters from cumulative probability values to successive blocks.

FIG. 7 illustrates the coefficients of clusters in a coefficient memory.

FIG. 8 is a block diagram of a synthesizer embodying this invention.

FIG. 9 illustrates a sequence of transition matrices.

FIG. 10 is a flow diagram of the steps used in synthesizing a signal in accordance with this invention.

FIG. 11 is a flow diagram showing the steps for obtaining the clusters utilized in an embodiment of this invention.

## Description of the Preferred Embodiment

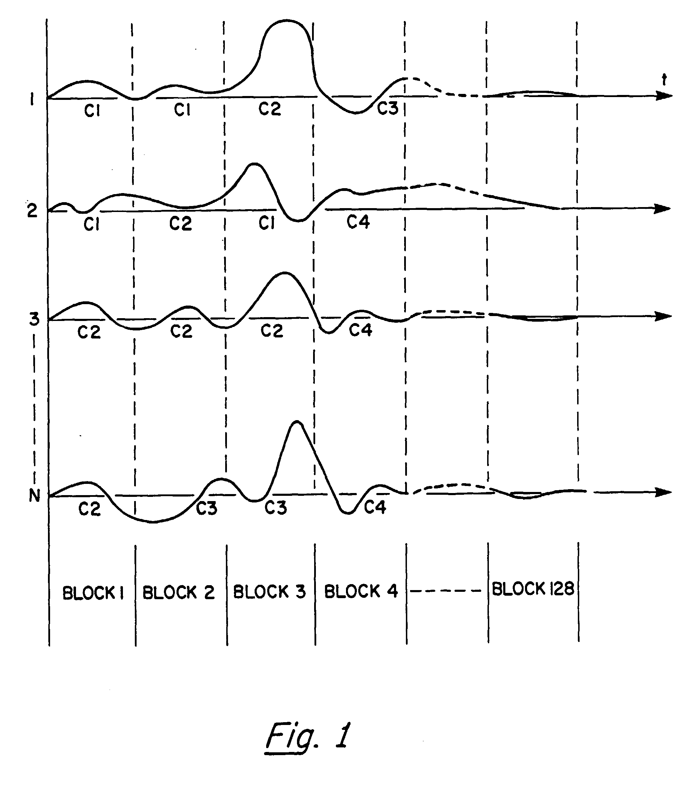

Referring to FIG. 1, there are shown waveforms 1, 2, 3, ..., N for transient sound signals, such as that produced by the closing of a hatch cover, each signal waveform being produced for each closing. As another example, each waveform could be one period of the cavitation noise produced by a rotating propeller. The gross features of each of the waveforms are oriented along the time axis so that they roughly correspond in time. For example, for the case of signal waveforms produced by the closing of a hatch cover, the initiation of the sound waveform for each of the succession of hatch closings should correspond to the same time, t=0. For the case of a cavitation signal produced by a rotating propeller, the beginning of a waveform period may not be so easily determined. However, the waveforms may be LPC analyzed to establish period starts by choosing as the start of the period that starting point which results in the minimum number of total clusters by a succession of LPC analyses using different cycle start times. Although the waveform of the analog signals produced by each closing of the hatch cover or propeller period will in general be different, the total number of different sets of coefficients which are obtained from LPC analysis of all the waveforms will be reduced in accordance with the method of this invention.

In LPC block-based analysis, many sets of coefficients are generated. By selecting a subset of these sets to represent all the blocks of data, then at the cost of some additional distortion, a reduced number of coefficients may be stored for synthesis. A smaller number of representative coefficient sets must be examined during the abstraction process by which a stochastic signature model is achieved.

A step toward achieving the goal of additional data compression can be taken by using vector quantization. In vector quantization, it is recognized that if the LPC coefficient sets are modified slightly, then some additional distortion will result,but that if the modification is small, then the resulting distortion will be minor. The measure of distortion which is utilized is related to subjective perception and is the likelihood ratio distortion measure. This measure is calculated by taking the ratio of the additional modeling error incurred by the use of a non-optimal modeling filter to that minimum error incurred by the use of the optimum filter. For any LPC coefficient set, this residual modeling error is calculated as

$$E_p = r_a(0)r_x(0) + 2\sum_{k=1}^{p} r_a(k)r_x(k),$$

where $r_a(k)$ is the autocorrelation of the filter coefficients a(k) which can be expressed in its un-normalized form as

$$r_a(k) = \sum_{n=0}^{p-k} a(n)a(n+k),$$

where p is the number of modelling filter coefficients. Also, $r_x(k)$ is the data autocorrelation function;

$$r_x(k) = \sum_{n=0}^{N-k} x(n)x(n+k),$$

where N is the number of samples in a block of the signal being analyzed. For the optimal set of coefficients determined, for example, by Levinson recursion, the residual modeling error is $\bar{E}_p$. $\bar{E}_p$ is the residual error from the optimal set of coefficients. The likelihood ratio distortion measure is then calculated as $D(A,\bar{A}) = (E_p - \bar{E}_p)/\bar{E}_p$. $\bar{A}$ is the optimal set of coefficients for the block, and A is one of the sets of coefficients (clusters) selected for each previous block. Typical values for $D(A,\bar{A})$ are in the range of 0.5-2. These values produce synthesized signals in which the distortion is sufficiently low for the synthesized sound to be a useful replica of the original sound from which the data was obtained for the synthesis procedure.

In this invention, therefore, a process is used which replaces each signature data block with a cluster such that the distortion is less than a predetermined threshold. If the representation of a data block by the LPC coefficients of any of the previously determined clusters cannot produce a distortion less than the threshold, then a new cluster based on the data block being examined is established. If the threshold is not exceeded, then the cluster producing the least representation distortion is utilized. The result of this vector quantization process is a set of clusters, that is, a group of data blocks is represented by clusters $C_i$, where $C_i \rightarrow \{a_i^i,...,a_p^i\}$ where $a_k^i$ is the kth coefficient of the ith cluster. As an example of the data compression available through vector quantization, a cavitation signature was acceptably vector quantized using 18 coefficient sets to represent 512 blocks of data. This is a compression ratio of nearly 30:1 over that of straightforward LPC analysis. Also, the ratio is limited by the length of the signature record being analyzed since the number of clusters required does not grow linearly with record length. These 18 clusters form the set upon which further modeling abstraction by Markov processes can be accomplished. Specifically, the mapping of the data blocks into clusters can be displayed in a cluster observation sequence. The objective of Markov signature analysis is to produce a probabilistic model which accurately describes the time evolution of the signature process across cluster assignments.

The waveforms shown in FIG. 1 are assumed to be reasonably close to the beginning of a period at the corresponding times. An LPC analysis on each waveform as described in the European Patent No. 0 209 336 is performed on blocks 1 - 128, where, if it is assumed that each block is 8 milliseconds in time duration, that the total time duration of the waveform to be analyzed is approximately one second, and that the number N of waveforms is ten, then 1280 sets of coefficients will be required i.e. one set of coefficients is produced from each block. Where the waveforms being analyzed are of longer duration such as, for example, one minute in length, the number of sets of coefficients will be significantly larger (sixty times in this example) and substantial memory must be utilized in order to digitally store each coefficient of each of the sets as in the referenced application.

To reduce the number of sets of coefficients, the sets are vector quantized so that the preceding illustration of 1280 sets of LPC coefficients for the ten waveforms are represented by a smaller number of sets (clusters) of coefficients. The sets of coefficients which can be replaced by one cluster are determined by the allowable limit on distortion where the threshold value is evaluated by the likelihood ratio distortion measure, as determined by the equation given hereinbefore. Thus,by way of illustration and depending upon the level of distortion which is acceptable, the 1280 sets of coefficients may be substantially reduced.

However, the generated signatures using vector quantization alone will be repetitive, whereas multiple examples of a real signature will exhibit random variations.

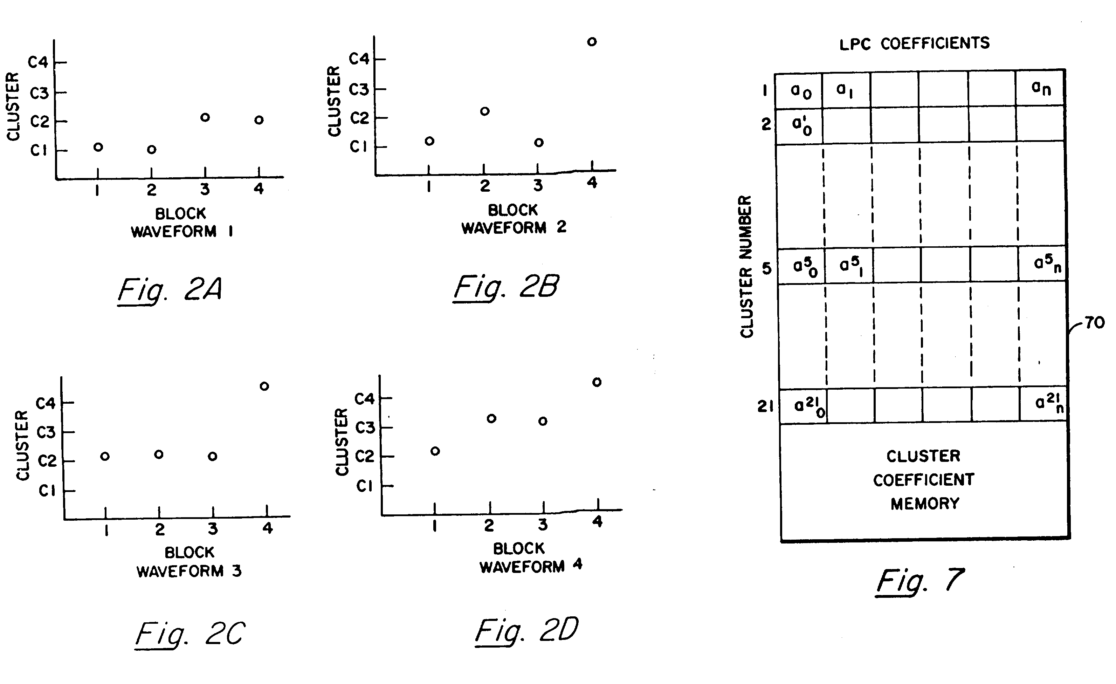

Each of the waveforms 1, 2,..., N of FIG. 1 are shown divided into eight millisecond blocks labeled 1, 2, 3,..., 128. Each block of each waveform when subjected to the LPC analysis produces a set of coefficients. The vector quantizing of these sets provides clusters (representative sets of LPC coefficients) less in number than the possible 128 sets of coefficients for each waveform 1,--,N. For waveform 1, it is assumed that the sets of coefficients for blocks 1 and 2 can be represented by one set of coefficients C1, where C1 are the coefficients calculated for block 1, the calculations of coefficients being performed by the LPC analysis. It is assumed that the set of LPC coefficients obtained for block 2 of waveform 1 when compared with the set of coefficients C1 results in the error being less than a prescribed amount, and hence the coefficients of cluster C1 are substituted for the coefficients calculated for block 2. The calculated LPC coefficients comprising the set for block 3 of waveform 1 are assumed to fall outside the prescribed allowable error when cluster C1 is compared with them. Hence the calculated LPC coefficients for block 3 are designated as cluster C2. This process is continued for all the blocks of all the waveforms 1, 2, 3,..., N whose sets of calculated LPC coefficients are evaluated relative to all previous clusters (in this example C1, C2) to determine whether additional cluster LPC coefficients need be established. The first four blocks of all the waveforms are assumed to be representable by the clusters C1,--, C4. FIGS. 2A-2D show the distribution of clusters C1-C4 for each block 1-4 for each waveform 1-3, and N, respectively. By way of example, FIGS. 2A-2D show that block 1 of each waveform has calculated LPC coefficients which have been replaced by the coefficients in either cluster C1 or cluster C2, whereas block 2 has calculated LPC coefficients which have been replaced by the coefficients of clusters 1, 2, or 3.

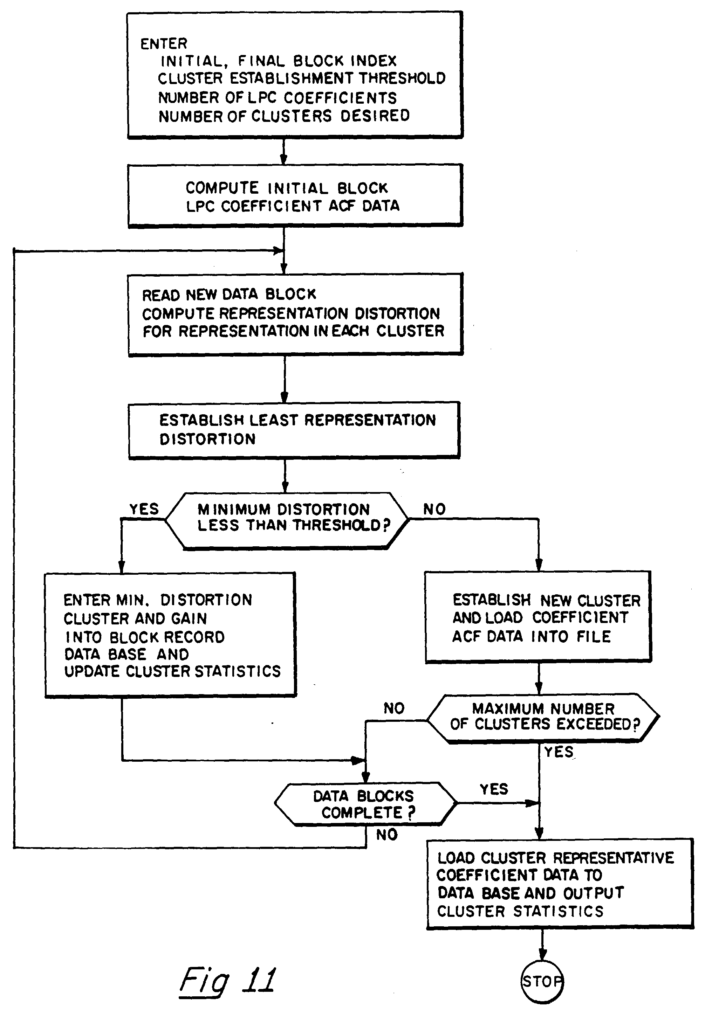

The algorithm which has been used in the preferred embodiment of this invention is a clustering algorithm, which differs from those of the prior art and is shown in the flow diagram of Figure 11. The program requires, as an input the index of the initial block to be used to start the distortion analysis as well as the cluster formation distortion threshold, the number of blocks to be analyzed, the block duration, and the number of LPC coefficients. With these inputs the analysis can be limited to any contiguous sequence of blocks in the data. The algorithm begins by storing the first block LPC coefficient autocorrelation function (ACF) data in memory. The next block of sampled data is retrieved from memory and the LPC coefficient ACF for this block is calculated, as well as the ACF of the sample data. Using this information, the representation distortion incurred by using the first set of LPC coefficients instead of the optimal set derived by Levenson recursion is calculated. If this distortion exceeds the cluster establishment threshold, then a new cluster is established, which is represented by the LPC coefficients of the new data block. In addition, the LPC coefficient ACF for the new cluster is stored in memory. If the distortion does not exceed the limit, then the data block is assigned to the first cluster. In an iterative fashion this process is repeated. Each sampled data block is read from the memory and the process of calculating the distortion incurred by using each previously established cluster is calculated. If the cluster establishment threshold is exceeded by each existing cluster, then a new cluster is established and coefficient data is again read into memory. If not, then the data block is assigned to the cluster which incurs the least representation distortion. Also, for each data block, the LPC gain value, the block index, and the cluster assignment are read to memory so that synthesis of the vector quantized signature can be accomplished. The process is continued until all data blocks have been examined. Finally, the LPC coefficients for each cluster are read in index fashion to memory also for use in synthesis. It is noted that the number of clusters established by this algorithm is largely a function of the chosen cluster establishment threshold. If the maximum number of clusters allowed is exceeded before all the data is examined, then the algorithm stops and a retry with a higher cluster establishment threshold is dictated. In practice, subsequent passes with successively lower establishment thresholds are conducted until the desired number of clusters is obtained.

This algorithm has proven extremely effective. For example, it required only four minutes to execute a single pass on 512 data blocks of eight millisecond duration, each containing 128 samples. It has been found that all 512 data blocks representing eight seconds of actual sound can be represented by less than two dozen coefficient sets for all of the long-term non-stationary signals examined.

A transition matrix is a matrix of elements $P_k(i, j)$, where $P_k(i,j)$ is the probability of a transition from cluster i at block k to cluster j at block k+1. The initial state occupancy vector (each state being associated with a cluster) is $P_o(i, j)$. These probability densities are estimated from the observed ensemble of multiple transient signature realizations, each of which is recorded and digitized. There exists a different transition matrix for each block transition and a different ordered set of transition matrices for each transient signature type.

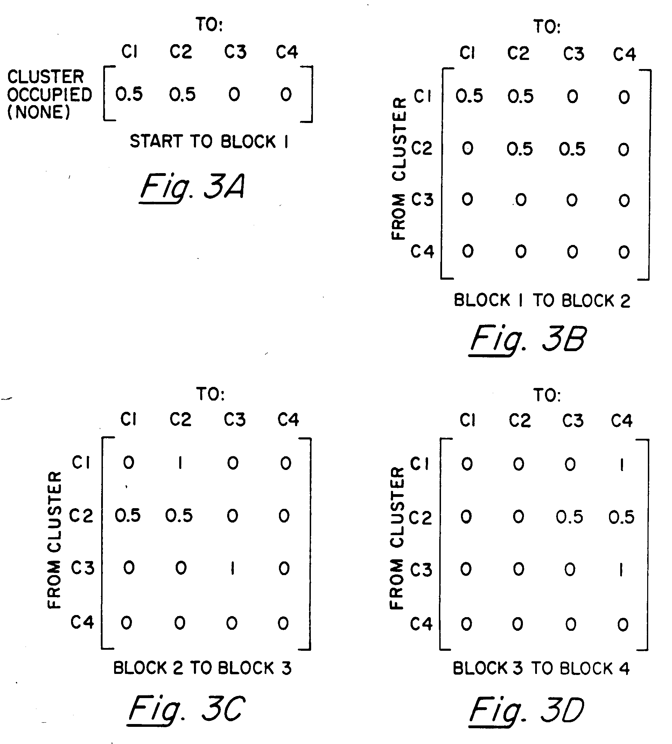

Referring now to FIGS. 3A-3D, there are shown the transition probability matrices for the transitions between one cluster to the same or a different cluster when it is desired to synthesize the waveform for the next succeeding block from a present block. For example, referring now to FIGS. 2A-2D for the transition from the cluster representing block 1 to the cluster representing block 2, it is seen that for block 1 the cluster is C1 for waveforms 1 and 2 with a transition to cluster C1 for waveform 1 and a transition from cluster C1 to cluster C2 for waveform 2. Waveforms 3 and N are seen to have cluster C2 during block 1 with a cluster C2 for block 2 of waveform 3 and a cluster C3 for block 2 of waveform N. Applying these cluster designations to the transition probability matrix illustrated in FIG. 3B for the transition from block 1 to block 2, it is seen that the transition from cluster C1 to the cluster C1 occurs half the time and the transition to cluster C2 occurs half the time. Similarly, the transition from cluster C2 to cluster C2 occurs half the time and the transition from cluster C2 to cluster C3 occurs half the time. For the limited number of waveforms being considered, there is no transition from clusters C3, C4 of block 1 to cluster C4 of block 2. Hence, these corresponding rows and columns have zero probability.

The cumulative probability matrix $P_k(i,j)$ consists of the accumulated probability densities,

$$P_k(i,j) = \sum_{m=1}^{j} p(i,m)$$

where k represents the data block.

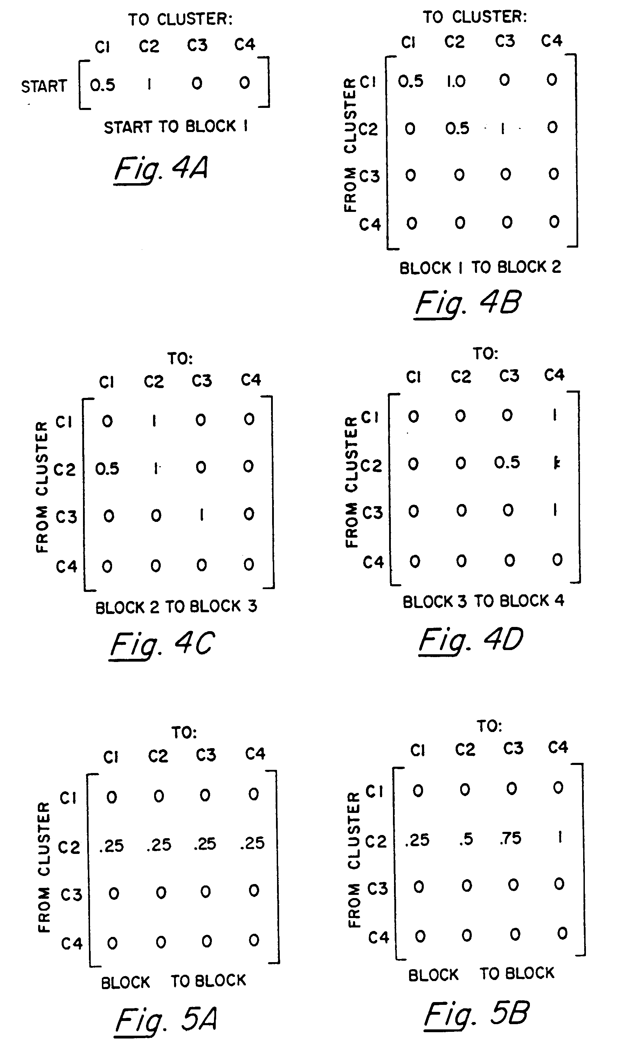

The cumulative probability matrixes shown in FIGS. 4A-4D are obtainable directly from each of the transition probability matrixes of FIGS. 3A-3D. Each column of a row of the transition probability matrix of FIG. 3 should serially accumulate probability densities as indicated in FIG. 4. FIG. 4 is utilized in the synthesis procedure. By utilizing a random number generator having values between 0 and 1 and including 1 to provide random numbers, the cluster transition from one block to the succeeding block given a particular cluster representing the one block is determined in accordance with the probability matrix. For example, referring to FIG. 4B, it is assumed that block 1 utilized cluster C2 in the synthesis procedure. Whether block 2 utilizes cluster C2 or C3 in the synthesis procedure is determined by the random number generator to be discussed subsequently. If the random number generator produces a number for the time period allocated to block 2 which is between 0 and 0.5 inclusive, then block 2 according to FIG. 4B will utilize the cluster C2 as the set of coefficients which is applied to the LPC filter during the time period corresponding to block 2. However, if the random number generator had produced a number greater than .5 and equal to or less than 1, then the cluster C3 would have been utilized during the time allocated to block 2 to generate the synthesized signal. It will be apparent to those skilled in the art that the probabilities associated with FIGS. 3A-3D and 4A-4D as well as the relative frequency of occurence of clusters are dependent upon the number of clusters which are possible in the transition from one block to the next successive block.

However, if instead it is assumed that block 1 of FIGS. 2A-2D had a cluster C2 as for waveforms 3 and N and that block 2 has clusters C1, C2, C3, C4 respectively for the four waveforms, then FIG. 3B would be modified so that the transition probability matrix would be as shown in FIG. 5A which shows equal probability, of transition from cluster C2 of block 1 to each of the clusters C1-C4 of block 2. FIG. 5B shows the cumulative probability matrix corresponding to the transition probability matrix of FIG. 5A which when utilized in conjunction with the random number generator selects with equal probability which of the clusters C1-C4 will be utilized in the svnthesis of the signal during block 2.

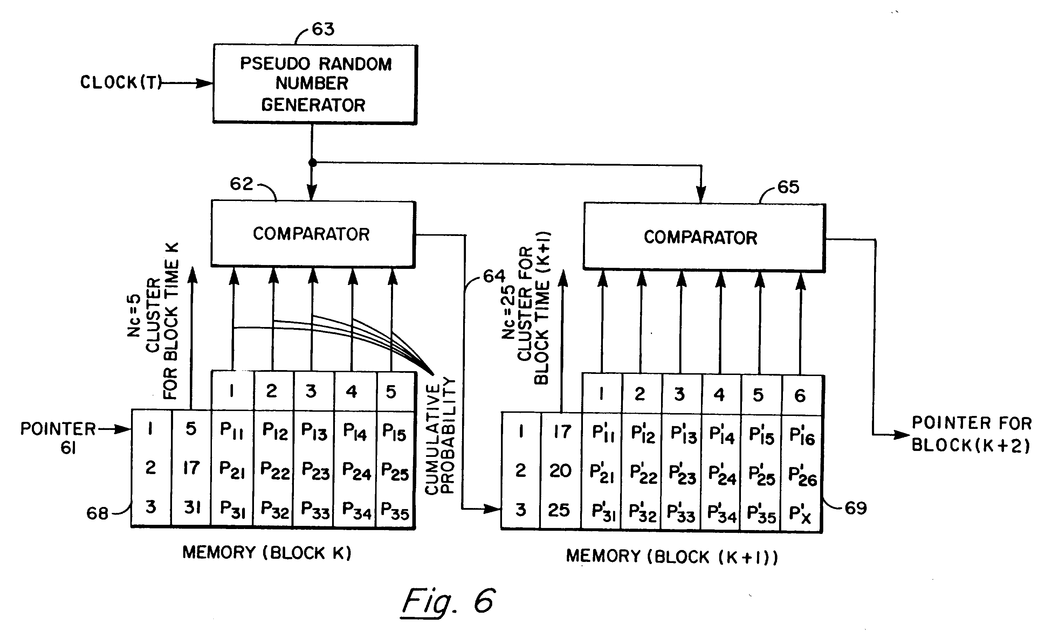

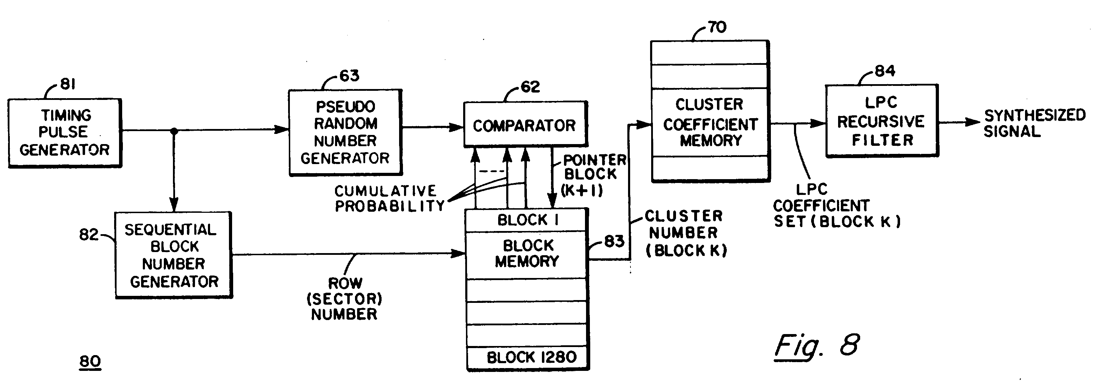

FIG. 6 represents the cumulative probability matrices for two successive blocks, block K and block K+1 in more general terms than that illustrated in FIGS. 4 and 5. FIG. 6 is also a representation of how the memory sectors 68, 69 which store and provide cluster data for each block K, (K+1), respectively, might be organized. It is assumed that a pointer 61 selects row 1 of a sector 68 of memory allocated to block K. The selection of row 1 provides cluster 5 for use in the LPC synthesis of block K. The LPC coefficients are contained in a memory 70 illustrated in FIG. 7 where the cluster number 5 designates row 5 in memory 70 which contains the LPC coefficients $a_0^5,....a_n^5$. The LPC coefficient memory 70 of FIG. 7 can be structured in the form of a ROM memory. Pointer 61 applied to row 1 also provides the cumulative probabilities $P_{11},..., P_{15}$ which are provided to a comparator 62, which has another input from a pseudo random generator 63. If it is assumed that the random number provided by generator 63 falls between the cumulative probability values P12 and P13 inclusive, the comparator will provide an output corresponding to column 3, which is provided as a pointer 64 to row 3 of the memory segment corresponding to block (K+1). Pointer 64 will, at the time corresponding to block (K+1), provide cluster 25 for block (K+1) and also provide all the cumulative probability values $P_{31}',...,P_{36}'$ to the comparator 65 for selection of one cluster for a time corresponding to block (K+2). It will be noted that a different number of columns corresponding to a different number of possible clusters appear in the block K and block (K+1) memory sectors 68, 69 respectively. Thus the pseudo random number generator 63 in conjunction with the cumulative transition probabilities of block K determines the selection of the row (and cluster) for block (K+1), and so on for all the blocks in succession.

A block diagram of the Markov synthesizer 80 is shown in FIG. 8. A timing pulse generator 81 produces a pulse every T milliseconds corresponding to a block time, where T has been chosen in this application to be 8 milliseconds. The pulse is provided to the pseudo random number generator 63 and to a sequential block number generator 82. The block number generator 82 selects a block address in sequential fashion which determines which block memory sector (such sectors 68, 69 of FIG. 6) is selected in block memory 83. As explained previously with respect to FIG. 6, a cluster number contained within the sector of memory 82 corresponding to block K is selected and the pdinter for block K is read out of memory 83 into the cluster coefficient memory 70 of FIG. 7. The cumulative probabilities provided by the same sector are provided to comparator 62, whose other input is provided by random number generator 63, to provide the cluster number and cumulative probabilities of block (K+1), and so on. The LPC coefficients for block K contained within memory 70 are selected by the cluster number from memory 83 block K and provided to a noise-excited LPC recursive synthesizer filter 84, described in detail in European Patent No. 0 209 336 which provides at its output the desired transient synthesized signature.

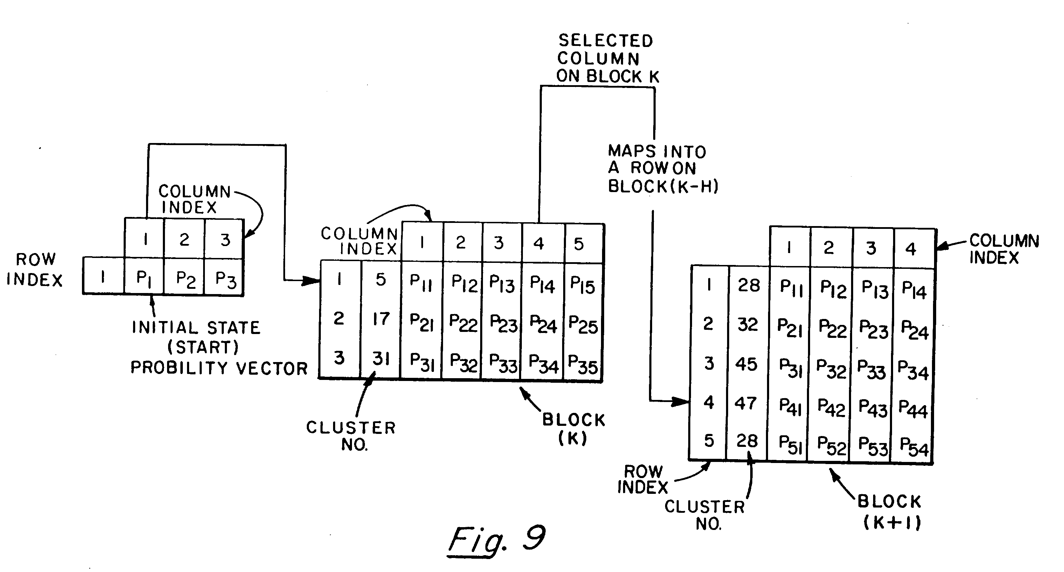

In summary, to synthesize a pseudo random signature using the direct Markov technique, a pseudo-random observation sequence must be generated from the Markov model discussed in the background section. This model is essentially a time varying Markov chain which consists of a set of states, an initial probability vector, and a set of transition matrices as shown in FIG. 9. Each matrix consists of rows and columns of transition probabilities, for example $P_{ij}$ in the $K^{th}$ matrix indicates the probability of entering row j on block K+1 given that the generator is in block i on block K. The entries are, therefore, discrete probability densities. Each row in addition contains an entry for the cluster set pointer. If the row is selected, then this entry points to the set of LPC coefficients to be used to synthesize the signal for block K.

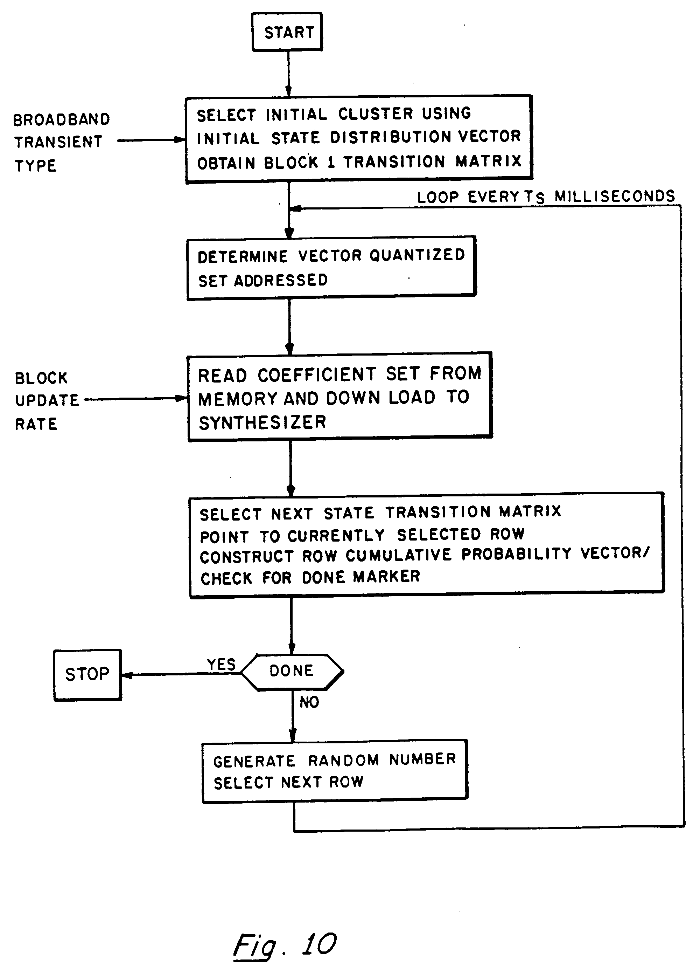

FIGs. 10 and 11 are flow diagrams of the synthesis and analysis process, respectively, of this invention which present in a different form the process steps described in the preceding specification.

Jointly quantized with each linear predictive coding coefficient cluster is quantized gain factor "A" where A is discussed in the referenced European Patent No. 0 209 336. Quantization of the gain factor A is determined by the minimum difference between the gain factor A and some prescribed set of allowable values of A. Thus, the quantized gain value together with the cluster coefficients comprise a set of representative cluster coefficients.

FIG. 10 illustrates, as a flow diagram, a method for synthesizing a signal from clustered linear prediction coded coefficients of blocks for the recursive filter, comprising the steps of:

selecting an initial cluster using an initial state distribution vector from the transition matrix of a first block;
determining a vector quantized coefficient set addressed by comparing with a random number;
reading a coefficient set from memory;

providing said coefficient set to said recursive filter for a time corresponding to a block update rate;

selecting a next state transition matrix to a currently selected row and constructing a row cumulative probability vector;

generating a random number; and

repeating the above steps beginning with determining a vector quantized coefficient set by comparing said row cumulative probability vector with said random number.

## Claims

1.  A method of synthesizing a desired signal, comprising supplying a random noise signal as input to a recursive filter (84) having a set of coefficient values which determine the output from the filter (84), while using, as the set of coefficient values of the filter (84) during each one of a sequence of block times (T) that corresponds to the duration of the desired signal, a selected set of linear predictive coding (LPC) coefficients ($a_o$, ....., $a_n$), each such set of LPC coefficients ($a_o$, ....., $a_n$) being selected from a plurality of stored sets (70) and supplied to the filter (84), <u>characterised in that</u> the selecting of and the supplying to the filter (84) of each set of LPC coefficients ($a_o$, ....., $a_n$) comprises the steps of:

    generating (81,63) a probability value;

    comparing (62) the generated probability value with a selected set of cumulative probability values ($P_{ij}$) derived from the transition probabilities between the stored sets, for the desired signal and determining the cumulative probability value ($P_{ij}$) indicated by the comparison in accordance with a predetermined criterion;

    selecting a respective one of the stored sets (70) corresponding to the indicated cumulative probability value ($P_{ij}$), each of the cumulative probability values ($P_{ij}$) being associated with a respective one of the stores sets (70) ;

    applying the selected stored set ($a_o$, ....., $a_n$) to the recursive filter (84) for the duration of a block time (T) ; and

    selecting, in dependence upon the said indicated cumulative probability value ($P_{ij}$), a next set of cumulative probability values ($P_{ij}$) for comparison with a next generated (63) probability value.

2.  A method according to claim 1, characterised in that each said set of cumulative probability values ($P_{ij}$) is constructed from a row of transition probability values in a respective stored matrix of transition probability values, a stored matrix of transition probability values being provided for each block time (T) in the said sequence, and the number of rows in the second one of each pair of neighbouring matrices in sequence equalling the number of columns in the first matrix of the pair.

3.  A method according to claim 2, characterised in that a single set of cumulative probability values is provided from which a first one of the stored sets (70) of LPC coefficients can be determined, the number of values in the said single set equalling the number of rows in the stored matrix for the first block time (T) in the sequence.

4.  A method according to any preceding claim, characterised in that the step of comparing (62) the generated probability value and determining the cumulative probability value ($P_{ij}$) includes selecting from the selected set of cumulative probability values ($P_{ij}$) the smallest value that is not smaller than the generated probability value.

5.  A method according to any preceding claim, characterised in that the step of selecting a respective one of the stored sets (70) includes accessing the stored sets (70) with a pointer ($N_o$) associated with the indicated cumulative probability value ($P_{ij}$).

6.  A method according to any preceding claim, characterised in that the stored sets (70) of LPC coefficients ($a_o$, ....., $a_n$) and the sets of cumulative probability values are provided by a process comprising the steps of:

    (i) providing a multiplicity of signals to be analysed, each signal to be analysed having a duration equal to the duration of the desired signal, and all the signals to be analysed having the same gross features, which occur at substantially the same times within the signals;

    (ii) sampling and dividing each signal to be analysed into the same number of blocks of samples, each block occupying a block time (T) of the desired signal;

    (iii) calculating a set of LPC coefficients for the recursive filter (84) for each block of each of the multiplicity of signals;

    (iv) selecting from the calculated sets of LPC coefficients a reduced number of calculated sets to serve as the said stored sets (70) by

(a) selecting a first set from the calculated sets and storing the selected first set,
(b) comparing another of the calculated sets with the selected first set,
(c) discarding the said other set if the difference between the selected first set and the other set does not exceed an allowable distortion limit, or selecting and storing the said other set if the said difference exceeds the allowable distortion limit,
(d) comparing a further one of the calculated sets with the selected stored sets and discarding the further set if the difference between the further set and any one of the selected stored sets does not exceed the allowable distortion limit, or selecting and storing the said further set if the respective differences between the said further set and all of the selected stored sets exceeds the allowable distortion limit, and
(e) repeating step (d) until each of the calculated sets has been either discarded or selected and stored;

(v) determining a respective sequence of the stored sets corresponding to each signal to be analysed;
(vi) calculating for each neighbouring pair of blocks in the sequence of blocks into which the signals to be analysed are divided the probability of transition from each possible stored set of LPC coefficients for the sequentially first block in the pair to each possible stored sets of LPC coefficients for the sequentially second block in the pair; and
(vii) calculating for each said neighbouring pair of blocks, from the transition probabilities calculated for that pair, a cumulative probability value ($P_{ij}$) for each calculated transition probability.

7. A method according to claim 6, characterised in that the transition probabilities for each said neighbouring pair of blocks are stored as a matrix, and a corresponding matrix of the cumulative probability values is calculated from each matrix of transition probabilities.

8. A method according to claim 6 or 7, characterised in that initial state probability values for possible ones of the selected stored sets of LPC coefficients for the first block in the said sequence of blocks are calculated, and initial state cumulative probability values are calculated from the calculated initial state probability values.

9. Apparatus for synthesizing a desired signal, comprising:

a recursive filter (84);
means for supplying a random noise signal as input to the recursive filter (84);
means (70) for supplying to the filter (84) for each one of a sequence of block times (T) a selected set of linear predictive coding (LPC) coefficients ($a_o$, ....., $a_n$), the sequence of block times (T) corresponding to the duration of the desired signal, and the filter (84) being such as to provide an output determined by the set of LPC coefficients supplied thereto, whereby the filter (84) produces during the sequence of block times (T) the desired signal in dependence upon the supplied sequence of sets of LPC coefficients; and
means (70) for storing the sets;

<u>characterised in that</u> the means for supplying the selected sets of LPC coefficients comprises:

means (81,63) for generating a probability value;
means (81,82,83) for supplying a selected set of cumulative probability values ($P_{ij}$) derived from the transition probabilities between the stored sets, for the desired signal, to the comparing means (62) ; and
means (62) for comparing a generated probability value with a selected set of cumulative probability values ($P_{ij}$), determining the cumulative probability value ($P_{ij}$) indicated by the comparison in accordance with a predetermined criterion, and selecting a respective one of the stored sets of LPC coefficients corresponding to the indicated cumulative probability value ($P_{ij}$) to be supplied to the filter (84), the means (81,82,83) for supplying a selected set of cumulative probability values ($P_{ij}$) including means (68,69) for associating each of the cumulative probability values ($P_{ij}$) with a respective one of the stored sets of LPC coefficients ($a_o$, ....., $a_n$), and for selecting, in dependence upon the said indicated cumulative probability value ($P_{ij}$), a next set of cumulative probability values ($P_{ij}$) for comparison with a next generated probability value.

10. Apparatus according to claim 9, characterised in that the means for generating a probability value comprises pseudo random number generating means (81,63) adapted to generate a pseudo random number for each block time (T).

**Patentansprüche**

1. Verfahren zur Synthese eines gewünschten Signales, umfassend

   Zuführen eines Zufalls-Störsignales als Eingang zu einem Rekursivfilter (84), der eine Gruppe von Koeffizientenwerten aufweist, welche den Ausgang von dem Filter (84) bestimmen, unter Verwenden eines ausgewählten Satzes von Koeffizienten $(a_0,.....,a_n)$ für die lineare vorhersagende Kodierung (LPC), als der Satz von Koeffizientenwerten des Filters (84) während jeder aus einer Folge von Blockzeiten (T), welche der Dauer des gewünschten Signales entspricht, wobei jeder solcher Satz von LPC-Koeffizienten $(a_0,.....,a_n)$ aus einer Anzahl von gespeicherten Sätzen (70) gewählt und zu dem Filter (84) geführt wird,

   dadurch gekennzeichnet, daß das Auswählen jedes Satzes von LPC-Koeffizienten $(a_0,.....,a_n)$ und sein Zuführen zu dem Filter (84) folgende Schritte umfaßt:

   Erzeugen (81,63) eines Wahrscheinlichkeitswertes;
   Vergleichen (62) des erzeugten Wahrscheinlichkeitswertes mit einem ausgewählten Satz von kumulativen Wahrscheinlichkeitswerten $(P_{ij})$ die von den übergangswahrscheinlichkeiten zwischen den gespeicherten Sätzen für die gewünschten Signale abgeleitet sind, und Bestimmen des kumulativen Wahrscheinlichkeitswertes $(P_{ij})$, der durch den Vergleich entsprechend einem vorbestimmten Kriterium bezeichnet ist;
   Auswählen eines jeweiligen der gespeicherten Sätze (70) entsprechend dem bezeichneten kumulativen Wahrscheinlichkeitswert $(P_{ij})$, wobei jeder der kumulativen Wahrscheinlichkeitswerte $(P_{ij})$ einem jeweiligen der gespeicherten Sätze (70) zugeordnet ist;
   Liefern des gewählten gespeicherten Satzes $(a_0,....a_n)$ zu dem Rekursivfilter (84) für die Dauer einer Blockzeit (T); und
   Auswählen eines nächsten Satzes von kumulativen Wahrscheinlichkeitswerten (Pij) für den Vergleich mit einem als nächstes erzeugten (63) Wahrscheinlichkeitswert in Abhängigkeit von dem genannten bezeichneten kumulativen Wahrscheinlichkeitswert (Pij).

2. Verfahren nach Anspruch 1, dadurch gekennzeichnet, daß jeder Satz von kumulativen Wahrscheinlichkeitswerten (Pij) aus einer Reihe von Übergangs-Wahrscheinlichkeitswerten in einer jeweiligen gespeicherten Matrix von Übergangs-Wahrscheinlichkeitswerten konstruiert wird, wobei eine gespeicherte Matrix von Übergangs-Wahrscheinlichkeitswerten für jede Blockzeit (T) in der genannten Folge vorgesehen ist und die Zahl der Zeilen in der jeweils zweiten jedes Paares benachbarter Matrizen in der Folge gleich der Anzahl von Spalten in der ersten Matrix des Paares ist.

3. Verfahren nach Anspruch 2, dadurch gekennzeichnet, daß ein einziger Satz von kumulativen Wahrscheinlichkeitswerten vorgesehen ist, von welchem ein erster der gespeicherten Sätze (70) von LPC-Koeffizienten bestimmt werden kann, wobei die Anzahl der Werte in dem genannten einzelnen Satz gleich der Anzahl von zeilen in der gespeicherten Matrix für die erste Blockzeit (T) in der Folge ist.

4. Verfahren nach irgendeinem vorhergehenden Anspruch, dadurch gekennzeichnet, daß der Schritt des Vergleichens (62) des erzeugten Wahrscheinlichkeitswertes und des Bestimmens des kumulativen Wahrscheinlichkeitswertes $(P_{ij})$ den Schritt des Auswählens des kleinsten Wertes, der nicht kleiner als der erzeugte Wahrscheinlichkeitswert ist, aus dem gewählten Satz von kumulativen Wahrscheinlichkeitswerten (Pij) umfaßt.

5. Verfahren nach irgendeinem vorhergehenden Anspruch, dadurch gekennzeichnet, daß der Schritt des Auswählens eines jeweiligen der gespeicherten Sätze (70) den Schritt des Zugreifens auf die gespeicherten Sätze (70) mit einem Zeiger $(N_c)$ umfaßt, der dem bezeichneten kumulativen Wahrscheinlichkeitswert $(P_{ij})$ zugeordnet ist.

6. Verfahren nach irgendeinem vorhergehenden Anspruch, dadurch gekennzeichnet, daß die gespeicherten Sätze (70) von LPC-Koeffizienten $(a_0,.....,a_n)$ und die Sätze von kumulativen Wahrscheinlichkeitswerten durch ein Verfahren gebildet werden, welches folgende Schritte umfaßt:

   (i) Vorsehen einer Vielzahl von Signalen, welche zu analysieren sind, wobei jedes zu analysierende Signal eine Dauer gleich der Dauer des gewünschten Signales hat und sämtliche zu analysierenden Signale dieselben Grobmerkmale besitzen, welche im wesentlichen zu gleichen Zeiten innerhalb des Signales auftauchen;
   (ii) Tasten und Teilen jedes zu analysierenden Signales in dieselbe Anzahl von Blöcken von Tastungen, wobei jeder Block eine Blockzeit (T) des gewünschten Signales einnimmt;
   (iii) Errechnen eines Satzes von LPC-Koeffizienten für den Rekursivfilter (84) für jeden Block jedes der Vielzahl von Signalen;

(iv) Auswählen einer reduzierten Anzahl von errechneten Sätzen aus den errechneten Sätzen von LPC-Koeffizienten, welch erstere als die gespeicherten Sätze (70) dienen, durch

(a) Auswählen eines ersten Satzes aus den errechneten Sätzen und Speichern des ausgewählten Satzes,
(b) Vergleichen eines anderen der errechneten Sätze mit dem ausgewählten ersten Satz,
(c) Verwerfen des genannten anderen Satzes, wenn die Differenz zwischen dem ausgewählten ersten Satz und dem anderen Satz nicht eine zulässige Verzerrungsgrenze übersteigt, oder Auswählen und Speichern des genannten anderen Satzes, wenn die genannte Differenz die zulässige Verzerrungsgrenze übersteigt,
(d) Vergleichen eines weiteren der errechneten Sätze mit den ausgewählten gespeicherten Sätzen und Verwerfen des weiteren Satzes, wenn die Differenz zwischen dem weiteren Satz und irgendeinem der ausgewählten gespeicherten Sätze die zulässige Verzerrungsgrenze nicht übersteigt, oder Auswählen und Speichern des genannten weiteren Satzes, wenn die jeweilige Differenz zwischen dem weiteren Satz und sämtlichen der ausgewählten gespeicherten Sätze die zulässige Verzerrungsgrenze übersteigt, und
(e) Wiederholen des Schrittes (d), bis jeder der errechneten Sätze entweder verworfen oder ausgewählt und gespeichert worden ist;

(v) Bestimmen einer jeweiligen Folge der gespeicherten Sätze entsprechend jedem zu analysierenden Signal;
(vi) Berechnen, und zwar für jedes benachbarte Paar von Blöcken in der Folge von Blöcken, in welche die zu analysierenden Signale unterteilt sind, der Wahrscheinlichkeit des Überganges von jedem möglichen gespeicherten Satz von LPC-Koeffizienten für den in der Folge ersten Block in dem Paar zu jedem möglichen gespeicherten Satz von LPC-Koeffizienten für den in der Folge zweiten Block in dem Paar; und
(vii) Errechnen eines kumulativen Wahrscheinlichkeitswertes ($P_{ij}$) für jede errechnete Übergangswahrscheinlichkeit für jedes genannte benachbarte Paar von Blöcken aus den Übergangswahrscheinlichkeiten, die für das Paar errechnet worden sind.

7. Verfahren nach Anspruch 6, dadurch gekennzeichnet, daß die Übergangswahrscheinlichkeiten für jedes genannte benachbarte Paar von Blöcken als Matrix gespeichert werden und daß eine entsprechende Matrix für die kumulativen Wahrscheinlichkeitswerte aus jeder Matrix von Übergangswahrscheinlichkeiten errechnet wird.

8. Verfahren nach Anspruch 6 oder 7, dadurch gekennzeichnet, daß die Anfangszustand-Wahrscheinlichkeitswerte für mögliche der ausgewählten gespeicherten Sätze von LPC-Koeffizienten für den ersten Block in der genannten Folge von Blöcken errechnet werden und kumulative Anfangszustand-Wahrscheinlichkeitswerte aus den errechneten Anfangszustand-Wahrscheinlichkeitswerten errechnet werden.

9. Einrichtung zur Synthese eines gewünschten Signales, enthaltend:

einen Rekursivfilter (84);
Mittel zur Zuführung eines Zufalls-Störsignales als Eingang zu dem Rekursivfilters (84);
Mittel (70) zum Zuführen eines ausgewählten Satzes von Koeffizienten ($a_0,....,a_n$) der linearen vorhersagenden Kodierung (LPC) zu dem Filter (84) für jede aus einer Folge von Blockzeiten (T), wobei die Folge von Blockzeiten (T) der Dauer des gewünschten Signales entspricht und der Filter (84) so ausgebildet ist, daß er einen Ausgang liefert, der durch den Satz von LPC-Koeffizienten, welche ihm zugeführt wurden, bestimmt ist, derart, daß der Filter (84) während der Folge von Blockzeiten (T) das gewünschte Signal in Abhängigkeit von der zugeführten Folge von Sätzen von LPC-Koeffizienten erzeugt; und
Mittel (70) zur Speicherung der Sätze;

dadurch gekennzeichnet, daß die Mittel zur Zuführung der ausgewählten Sätze von LPC-Koeffizienten folgendes enthalten:

Mittel (81, 63) zur Erzeugung eines Wahrscheinlichkeitswertes;
Mittel (81, 82, 83) zur Tastung eines gewählten Satzes von kumulativen Wahrscheinlichkeitswerten ($P_{ij}$), die von den Übergangswahrscheinlichkeiten zwischen den gespeicherten Sätzen für das gewünschte Signal abgeleitet sind, zu den vergleichenden Mitteln (62); und
Mittel (62) für den Vergleich eines erzeugten Wahrscheinlichkeitswertes mit einem gewählten Satz von kumulativen Wahrscheinlichkeitswerten ($P_{ij}$), zum Bestimmen des kumulativen Wahrscheinlichkeitswertes ($P_{ij}$), der durch den Vergleich entsprechend einem vorbestimmten Kriterium bezeichnet worden ist, und zum Auswählen eines jeweiligen der gespeicherten Sätze von LPC-Koeffizienten entsprechend dem bezeichneten kumulativen

Wahrscheinlichkeitswert ($P_{ij}$), der zu dem Filter (84) zu führen ist, wobei die Mittel (81, 82, 83) zur Lieferung eines gewählten Satzes von kumulativen Wahrscheinlichkeitswerten ($P_{ij}$) weitere Mittel (68, 69) zur Zuordnung jedes der kumulativen Wahrscheinlichkeitswerte ($P_{ij}$) zu einem jeweiligen der gespeicherten Sätze von LPC-Koeffizienten ($a_0$,....,$a_n$) und zur Auswahl eines nächsten Satzes von kumulativen Wahrscheinlichkeitswerten ($P_{ij}$) für den Vergleich mit einem als nächstes erzeugten Wahrscheinlichkeitswert in Abhängigkeit von dem bezeichneten kumulativen Wahrscheinlichkeitswert ($P_{ij}$) enthalten.

**10.** Einrichtung nach Anspruch 9, dadurch gekennzeichnet, daß die Mittel zur Erzeugung eines Wahrscheinlichkeitswertes Pseudozufallszahl-Generatomittel (81, 63) enthalten, welche für jede Blockzeit (T) eine Pseudozufallszahl zu erzeugen vermögen.

## Revendications

**1.** Procédé de synthèse d'un signal souhaité, comprenant l'application d'un signal de bruit aléatoire comme entrée d'un filtre récursif (84) ayant une série de valeurs de coefficient qui déterminent la sortie du filtre (84), tout en utilisant, en tant que série de valeurs de coefficient du filtre (84) au cours de chacun d'une séquence de temps de blocs (T) qui correspond à la durée du signal souhaité, une série sélectionnée de coefficients de codage prédictif linéaire (LPC) ($a_0$, ..., $a_n$), que série de coefficients LPC ($a_0$, ..., $a_n$) étant sélectionnée à partir d'une pluralité de séries stockées (70), et appliqué eau filtre (84),
caractérisé en ce que la sélection et l'application au filtre (84) de chaque série de coefficients LPC ($a_0$, ..., $a_n$) comprend les étapes suivantes:

génération (81, 63) d'une valeur de probabilité;
comparaison (62) de la valeur de probabilité générée avec une série sélectionnée de valeurs de probabilité cumulatives ($P_{ij}$) provenant des probabilités de transition entre les séries stockées, pour le signal souhaité, et détermination de la valeur de probabilité cumulative ($P_{ij}$) indiquées par la comparaison selon un critère prédéterminé ;
sélection d'une série respective des séries stockées (70) correspondant à la valeur de la probabilité cumulative ($P_{ij}$) indiquée, chacune des valeurs de probabilité cumulative ($P_{ij}$) étant associée à une série respective parmi les séries stockées (70);
application de la série stockée sélectionnée ($a_0$, ..., $a_n$) au filtre récursif (84) pendant la durée d'un temps de bloc (T) ; et
sélection, en fonction de ladite valeur de probabilité cumulative indiquée ($P_{ij}$), d'une série suivante de valeurs de probabilité cumulatives ($P_{ij}$) pour la comparaison avec une valeur de probabilité générée ensuite (63).

**2.** Procédé selon la revendication 1, caractérisé en ce que chacune de ladite série de valeurs de probabilité cumulatives ($P_{ij}$) est constituée à partir d'une rangée de valeurs de probabilité de transition dans une matrice stockée respective de valeurs de probabilité de transition, une matrice stockée de valeurs de probabilité de transition étant utilisée pour chaque temps de bloc (T) dans ladite séquence, et le nombre de rangées dans la seconde de chaque paire de matrices voisines en séquence étant égal au nombre de colonnes dans la première matrice de la paire.

**3.** Procédé selon la revendication 2, caractérisé en ce qu'une seule série de valeurs de probabilité cumulatives est prévue, à partir de laquelle une première des séries stockées (70) de coefficients LPC peut être déterminée, le nombre de valeurs dans ladite seule série étant égal au nombre de rangées dans la matrice stockée pour le premier temps de bloc (T) dans la séquence.

**4.** Procédé selon l'une quelconque des revendications précédentes, caractérisé en ce que l'étape de comparaison (62) de la valeur de probabilité générée et de détermination de la valeur de probabilité cumulative ($P_{ij}$) comporte la sélection, à partir de la série sélectionnée de valeurs de probabilité cumulatives ($P_{ij}$), de la plus petite valeur qui n'est pas inférieure à la valeur de probabilité générée.

**5.** Procédé selon l'une quelconque des revendications précédentes, caractérisé en ce que l'étape de sélection d'une série respective des séries stockées (70) comporte l'accès aux séries stockées (70) avec un pointeur ($N_c$) associé à la valeur de probabilité cumulative indiquée ($P_{ij}$).

**6.** Procédé selon l'une quelconque des revendications précédentes, caractérisé en ce que les séries stockées (70) de coefficients LPC ($a_0$, ..., $a_n$) et les séries de valeurs de probabilité cumulatives sont utilisées par un traitement comprenant les étapes suivantes:

(i) utilisation d'une multiplicité de signaux à analyser, chaque signal à analyser ayant une durée égale à la durée du signal souhaité, et tous les signaux à analyser ayant les mêmes caractéristiques brutes, qui apparaissent sensiblement aux mêmes instants dans les signaux;

(ii) échantillonnage et division de chaque signal à analyser en un nombre identique de blocs d'échantillons, chaque bloc occupant un temps de bloc (T) du signal souhaité;

(iii) calcul d'une série de coefficients LPC pour le filtre récursif (84), pour chaque bloc de chacun de la multiplicité de signaux;

(iv) sélection, à partir des séries calculées de coefficients LPC, d'un nombre réduit de séries calculées pour servir en tant que séries stockées (70) par :

(a) sélection d'une première série à partir des séries calculées et stockage de la première série sélectionnée,

(b) comparaison d'une autre des séries calculées avec la première série sélectionnée,

(c) mise à l'écart de ladite autre série si la différence entre la première série sélectionnée et l'autre série n'excède pas une limite de distorsion permise, ou sélection et stockage de ladite autre série si ladite différence excède la limite de distorsion permise,

(d) comparaison d'une autre des séries calculées avec les séries stockées sélectionnées et mise à l'écart de l'autre série si la différence entre l'autre série et l'une quelconque des séries stockées sélectionnées n'excède pas la limite de distorsion permise, ou sélection et stockage de ladite autre série si les différences respectives entre ladite autre série et toutes les séries stockées sélectionnées excède la limite de distorsion permise, et

(e) répétition de l'étape (d) jusqu'à ce que chacune des séries calculées ait été, soit écartée, soit sélectionnée et stockée;

(v) détermination d'une séquence respective des séries stockées correspondant à chaque signal à analyser;

(vi) calcul, pour chaque paire voisine de blocs dans la séquence de blocs en laquelle les signaux à analyser sont divisés, de la probabilité de transition entre chaque série stockée possible de coefficients LPC pour le premier bloc séquentiellement dans la paire, et chaque série stockée possible de coefficients LPC pour le second bloc séquentiellement dans la paire; et

(vii) calcul, pour chaque paire voisine de blocs, à partir des probabilités de transition calculées pour cette paire, d'une valeur de probabilité cumulative ($P_{ij}$) pour chaque probabilité de transition calculée.

7. Procédé selon la revendication 6, caractérisé en ce que les probabilités de transition pour chaque paire voisine de blocs sont stockées sous la forme d'une matrice, et une matrice correspondante de valeurs de probabilité cumulatives est calculée à partir de chaque matrice de probabilités de transition.

8. Procédé selon la revendication 6 ou 7, caractérisé en ce que les valeurs de probabilité d'état initial, pour des séries possibles des séries stockées sélectionnées de coefficients LPC pour le premier bloc dans ladite séquence de blocs, sont calculées, et des valeurs de probabilité cumulatives à l'état initial sont calculées à partir des valeurs de probabilité à l'état initial.

9. Appareil pour synthétiser un signal souhaité, comprenant:

un filtre récursif (84);

un moyen pour appliquer un signal de bruit aléatoire sous forme d'entrée au filtre récursif (84);

un moyen (70) pour appliquer au filtre (84), pour chacun d'une séquence de temps de bloc (T), une série sélectionnée de coefficients ($a_0$, ..., $a_n$) de codage prédictif linéaire (LPC), la séquence de temps de bloc (T) correspondant à la durée du signal souhaité, et le filtre (84) étant tel qu'il fournit une sortie déterminée par la série de coefficients LPC qui lui sont appliqués, à la suite de quoi le filtre (84) produit, au cours de la séquence de temps de bloc (T), le signal souhaité en fonction de la séquence appliquée de séries de coefficients LPC; et

un moyen (70) pour stocker les séries;

caractérisé en ce que le moyen pour appliquer les séries sélectionnées de coefficients LPC comprend:

un moyen (81, 63) pour générer une valeur de probabilité;

un moyen (81, 82, 83) pour appliquer une série sélectionnée de valeurs de probabilité cumulatives ($P_{ij}$) pro-

venant des probabilités de transition entre les séries stockées, pour le signal souhaité, au moyen de comparaison (62); et

un moyen (62) pour comparer une valeur de probabilité générée avec une série sélectionnée de valeurs de probabilité cumulatives ($P_{ij}$) déterminant la valeur de probabilité cumulative ($P_{ij}$) indiquée par la comparaison en fonction d'un critère prédéterminé, et pour sélectionner une série respective des séries stockées de coefficients LPC correspondant à la valeur de probabilité cumulative indiquée ($P_{ij}$) à appliquer au filtre (84), le moyen (81, 82, 83) pour appliquer une série sélectionnée de valeurs de probabilité cumulatives ($P_{ij}$) comportant un moyen (68, 69) pour associer chacune des valeurs de probabilité cumulatives ($P_{ij}$) avec une série respective des séries stockées de coefficients LPC ($a_0$, ..., $a_n$) et pour sélectionner, en fonction de la valeur de probabilité cumulative indiquée ($P_{ij}$), une série suivante de valeurs de probabilité cumulatives ($P_{ij}$) pour la comparaison avec une valeur de probabilité générée suivante.

10. Appareil selon la revendication 9, caractérisé en ce que le moyen pour générer une valeur de probabilité comprend un moyen (81, 63) de génération de nombre pseudo-aléatoire pour chaque temps de bloc (T).

_Fig. 1_

Fig. 7

LPC COEFFICIENTS

CLUSTER NUMBER

CLUSTER COEFFICIENT MEMORY

$a_0$ $a_1$ $a_n$
$a^1_0$
$a^5_0$ $a^5_1$ $a^5_n$
$a^{21}_0$ $a^{21}_n$

70

Fig. 2A

CLUSTER

C4 C3 C2 C1

BLOCK WAVEFORM 1

1 2 3 4

Fig. 2B

CLUSTER

C4 C3 C2 C1

BLOCK WAVEFORM 2

1 2 3 4

Fig. 2C

CLUSTER

C4 C3 C2 C1

BLOCK WAVEFORM 3

1 2 3 4

Fig. 2D

CLUSTER

C4 C3 C2 C1

BLOCK WAVEFORM 4

1 2 3 4

16

TO:

|  | CI | C2 | C3 | C4 |
|---|---|---|---|---|
| CLUSTER OCCUPIED (NONE) | 0.5 | 0.5 | O | O |

START TO BLOCK I

*Fig. 3A*

TO:

FROM CLUSTER

|  | CI | C2 | C3 | C4 |
|---|---|---|---|---|
| CI | 0.5 | 0.5 | O | O |
| C2 | O | 0.5 | 0.5 | O |
| C3 | O | .O | O | O |
| C4 | O | O | O | O |

BLOCK I TO BLOCK 2

*Fig. 3B*

TO:

FROM CLUSTER

|  | CI | C2 | C3 | C4 |
|---|---|---|---|---|
| CI | O | I | O | O |
| C2 | 0.5 | 0.5 | O | O |
| C3 | O | O | I | O |
| C4 | O | O | O | O |

BLOCK 2 TO BLOCK 3

*Fig. 3C*

TO:

FROM CLUSTER

|  | CI | C2 | C3 | C4 |
|---|---|---|---|---|
| CI | O | O | O | I |
| C2 | O | O | 0.5 | 0.5 |
| C3 | O | O | O | I |
| C4 | O | O | O | O |

BLOCK 3 TO BLOCK 4

*Fig. 3D*

TO CLUSTER:

|  | C1 | C2 | C3 | C4 |
|---|---|---|---|---|
| START | 0.5 | I | O | O |

START TO BLOCK I

**Fig. 4A**

TO CLUSTER:

| FROM CLUSTER | C1 | C2 | C3 | C4 |
|---|---|---|---|---|
| C1 | 0.5 | 1.0 | O | O |
| C2 | O | 0.5 | I | O |
| C3 | O | O | O | O |
| C4 | O | O | O | O |

BLOCK I TO BLOCK 2

**Fig. 4B**

TO:

| FROM CLUSTER | C1 | C2 | C3 | C4 |
|---|---|---|---|---|
| C1 | O | I | O | O |
| C2 | 0.5 | I | O | O |
| C3 | O | O | I | O |
| C4 | O | O | O | O |

BLOCK 2 TO BLOCK 3

**Fig. 4C**

TO:

| FROM CLUSTER | C1 | C2 | C3 | C4 |
|---|---|---|---|---|
| C1 | O | O | O | I |
| C2 | O | O | 0.5 | I |
| C3 | O | O | O | I |
| C4 | O | O | O | O |

BLOCK 3 TO BLOCK 4

**Fig. 4D**

TO:

| FROM CLUSTER | C1 | C2 | C3 | C4 |
|---|---|---|---|---|
| C1 | O | O | O | O |
| C2 | .25 | .25 | .25 | .25 |
| C3 | O | O | O | O |
| C4 | O | O | O | O |

BLOCK TO BLOCK

**Fig. 5A**

TO:

| FROM CLUSTER | C1 | C2 | C3 | C4 |
|---|---|---|---|---|
| C1 | O | O | O | O |
| C2 | .25 | .5 | .75 | I |
| C3 | O | O | O | O |
| C4 | O | O | O | O |

BLOCK TO BLOCK

**Fig. 5B**

EP 0 436 397 B1

*Fig. 6*

Fig. 8

EP 0 436 397 B1

SELECTED
COLUMN
ON BLOCK K

MAPS INTO
A ROW ON
BLOCK(K-H)

COLUMN
INDEX

ROW
INDEX

| | 1 | 2 | 3 |
|---|---|---|---|
| 1 | $P_1$ | $P_2$ | $P_3$ |

INITIAL STATE
(START)
PROBILITY VECTOR

COLUMN
INDEX

| | | 1 | 2 | 3 | 4 | 5 |
|---|---|---|---|---|---|---|
| 1 | 5 | $P_{11}$ | $P_{12}$ | $P_{13}$ | $P_{14}$ | $P_{15}$ |
| 2 | 17 | $P_{21}$ | $P_{22}$ | $P_{23}$ | $P_{24}$ | $P_{25}$ |
| 3 | 31 | $P_{31}$ | $P_{32}$ | $P_{33}$ | $P_{34}$ | $P_{35}$ |

CLUSTER
NO.

BLOCK
(K)

COLUMN
INDEX

| | | 1 | 2 | 3 | 4 |
|---|---|---|---|---|---|
| 1 | 28 | $P_{11}$ | $P_{12}$ | $P_{13}$ | $P_{14}$ |
| 2 | 32 | $P_{21}$ | $P_{22}$ | $P_{23}$ | $P_{24}$ |
| 3 | 45 | $P_{31}$ | $P_{32}$ | $P_{33}$ | $P_{34}$ |
| 4 | 47 | $P_{41}$ | $P_{42}$ | $P_{43}$ | $P_{44}$ |
| 5 | 28 | $P_{51}$ | $P_{52}$ | $P_{53}$ | $P_{54}$ |

ROW
INDEX

CLUSTER
NO.

BLOCK
(K+1)

*Fig. 9*

START

BROADBAND
TRANSIENT
TYPE

→ SELECT INITIAL CLUSTER USING
INITIAL STATE DISTRIBUTION VECTOR
OBTAIN BLOCK 1 TRANSITION MATRIX

LOOP EVERY $T_S$ MILLISECONDS

DETERMINE VECTOR QUANTIZED
SET ADDRESSED

BLOCK
UPDATE
RATE

→ READ COEFFICIENT SET FROM
MEMORY AND DOWN LOAD TO
SYNTHESIZER

SELECT NEXT STATE TRANSITION MATRIX
POINT TO CURRENTLY SELECTED ROW
CONSTRUCT ROW CUMULATIVE PROBABILITY VECTOR/
CHECK FOR DONE MARKER

STOP ← YES ── DONE

NO

GENERATE RANDOM NUMBER
SELECT NEXT ROW

_Fig. 10_

*Fig 11*